# EUROPÄISCHE PATENTSCHRIFT

(11) **EP 2 030 315 B1**
(45) Veröffentlichungstag und Bekanntmachung des Hinweises auf die Patenterteilung: **13.03.2013**
(21) Anmeldenummer: 08701513.7
(22) Anmeldetag: 16.01.2008
(51) Int. Cl.: H02M 7/5383, H03B 5/06, H03L 3/00

(54) **Anschwinghilfe für eine Oszillatorschaltung**
Starting means for an oscillatory circuit
Circuit de démarrage pour un oscillateur

(30) Priorität: 31.01.2007 DE 102007004817
(43) Veröffentlichungstag der Anmeldung: 04.03.2009
(73) Patentinhaber: Continental Automotive GmbH, 30165 Hannover (DE)
(72) Erfinder: BOLZ, Stephan, 93102 Pfatter (DE)
(86) Internationale Anmeldenummer: PCT/EP2008/050427
(87) Internationale Veröffentlichungsnummer: WO 2008/092742

(56) Entgegenhaltungen:
- EP-A- 0 709 965
- EP-A- 1 179 886
- US-A- 3 469 211
- US-A- 4 617 620

## Beschreibung

Die Erfindung betrifft eine Vorrichtung mit einer Oszillatoreinheit, die mit einer elektrischen Last koppelbar ist zum Zuführen von elektrischer Energie zu der elektrischen Last.

Die elektrische Energie soll der elektrischen Last in Form einer Wechselspannung mit einer vorgegebenen Frequenz und einer vorgegebenen Spannungsamplitude zugeführt werden. Diese Wechselspannung wird mittels der Oszillatoreinheit erzeugt. Abhängig von der elektrischen Last kann jedoch ein Anschwingen der Oszillatoreinheit beeinträchtigt sein.

Die EP 1179886 A2 offenbart eine Oszillatorschaltung mit Hilfsoszillator zum sicheren Anschwingen. Die US 4,617,620 offenbart einen Wandler mit Oszillatorschaltung, bei dem zum sicheren Anschwingen die Schleifenversärkung erhöht wird.

Die Aufgabe der Erfindung ist, eine Vorrichtung mit einer Oszillatoreinheit zu schaffen, die zuverlässig anschwingt.

Die Aufgabe wird gelöst durch die Merkmale der unabhängigen Patentansprüche. Vorteilhafte Weiterbildungen der Erfindung sind in den Unteransprüchen gekennzeichnet.

Die Erfindung zeichnet sich aus durch eine Vorrichtung, die mit einer elektrischen Last koppelbar ist zum Zuführen von elektrischer Energie zu der elektrischen Last. Die Vorrichtung umfasst eine Oszillatoreinheit und eine Hilfsoszillatoreinheit. Die Oszillatoreinheit ist ausgebildet, ein Ausgangssignal der Vorrichtung zu erzeugen, das der elektrischen Last zuführbar ist und das eine erste Frequenz aufweist. Die Hilfsoszillatoreinheit ist mit der Oszillatoreinheit elektrisch gekoppelt. Die Hilfsoszillatoreinheit ist ferner ausgebildet, die Oszillatoreinheit zum Schwingen anzuregen mit einer zweiten Frequenz, die größer ist als die erste Frequenz. Die Hilfsoszillatoreinheit umfasst ein Zeitglied, das ausgebildet und angeordnet ist, das Anregen der Oszillatoreinheit nach Ablauf einer vorgegebenen Zeitdauer nach einem Start der Oszillatoreinheit und der Hilfsoszillatoreinheit zu beenden.

Die Erfindung beruht auf der Erkenntnis, dass das Anschwingen der Oszillatoreinheit beeinträchtigt sein kann, wenn die elektrische Last einen zu geringen Lastwiderstand aufweist. Eine Leerlaufverstärkung der Oszillatoreinheit kann durch den geringen Lastwiderstand zu sehr reduziert sein, um ein zuverlässiges Anschwingen der Oszillatoreinheit gewährleisten zu können. Durch Vorsehen der Hilfsoszillatoreinheit ist ein kontrolliertes und zuverlässiges Anschwingen der Oszillatoreinheit möglich, indem die Oszillatoreinheit mit der Hilfsoszillatoreinheit zwangssynchronisiert wird. Nach Ablauf der vorgegebenen Zeitdauer, die beispielsweise in einer Größenordnung von etwa 100 Mikrosekunden oder Millisekunden liegt, kann die Oszillatoreinheit dann mit ihrer eigenen, ersten Frequenz schwingen. Dadurch ist ein verlustarmer Betrieb der Oszillatoreinheit möglich. Ferner ist eine solche Vorrichtung einfach und kostengünstig implementierbar. Die Oszillatoreinheit ist insbesondere eine Leistungsoszillatoreinheit.

Die Erfindung ist besonders geeignet für ein Übertragen elektrischer Energie zu der elektrischen Last in Form des Ausgangssignals, das insbesondere ein differenzielles Ausgangssignal in Bezug auf ein vorgegebenes Bezugspotential ist, zum . Betreiben der elektrischen Last, beispielsweise zum Betreiben einer Heizung, insbesondere einer induktiven Heizung eines Kraftstoffeinspritzventils in einem Kraftfahrzeug. Die Vorrichtung ist insbesondere ein Steuergerät in dem Kraftfahrzeug.

In einer vorteilhaften Ausgestaltung umfasst die Oszillatoreinheit mindestens einen Transistor, der einen Schleifenverstärker für das Erzeugen des Ausgangssignals repräsentiert. Die Hilfsoszillatoreinheit ist mit einem Steuereingang des mindestens einen Transistors gekoppelt zum Ansteuern des mindestens einen Transistors. Dies hat den Vorteil, dass dadurch das Schalten des mindestens einen Transistors auf diese Weise durch die Hilfsoszillatoreinheit steuerbar ist. Das Schalten erfolgt daher kontrolliert und wie durch die Hilfsoszillatoreinheit vorgegeben. Für das Ansteuern des mindestens einen Transistors ist nur eine geringe Leistung erforderlich, so dass die Hilfsoszillatoreinheit kostengünstig ausgebildet sein kann. Der mindestens eine Transistor ist insbesondere als ein Leistungstransistor ausgebildet.

In diesem Zusammenhang ist es vorteilhaft, wenn in der Oszillatoreinheit zwei Transistoren vorgesehen sind, die jeweils einen Schleifenverstärker für das Erzeugen des Ausgangssignals repräsentieren, und die Hilfsoszillatoreinheit ausgebildet ist, die zwei Transistoren abwechselnd anzusteuern. Durch die zwei Transistoren ist insbesondere das differenzielle Ausgangssignal erzeugbar, das im Wesentlichen symmetrisch zu dem vorgegebenen Bezugspotential ist. Der Vorteil ist, dass die zwei Transistoren nicht gleichzeitig durchgeschaltet sind. Dadurch kann die Entstehung einer Stromspitze während des Anschwingens der Oszillatoreinheit verhindert werden. Eine solche Stromspitze stellt eine große Belastung für die Bauelemente der Oszillatoreinheit und insbesondere für den mindestens einen Transistor dar und kann zu einer verringerten Lebensdauer und Zuverlässigkeit der Oszillatoreinheit führen. Durch das Verhindern der Entstehung der Stromspitze wird die Zuverlässigkeit und die Lebensdauer der Oszillatoreinheit daher erhalten. Ferner kann die Stromspitze auch zu einer störenden elektromagnetischen Abstrahlung führen, die gegebenenfalls durch teure Filtermaßnahmen unterdrückt werden muss. Durch das Verhindern der Entstehung der Stromspitze sind solche Filtermaßnahmen jedoch nicht erforderlich. Die Vorrichtung kann daher besonders kostengünstig ausgebildet sein.

In einer weiteren vorteilhaften Ausgestaltung weisen die Oszillatoreinheit und die Hilfsoszillatoreinheit einen gemeinsamen Aktivierungseingang auf. Die Oszillatoreinheit ist ausgebildet, ein Zuführen einer Vorspannung, die für das Erzeugen der Ausgangsspannung erforderlich ist, zu dem Steueranschluss des mindestens einen Transistors abhängig von einem Aktivierungssignal an dem Aktivierungseingang zu aktivieren oder deaktivieren. Ferner ist die Hilfsoszillatoreinheit ausgebildet, das Zeitglied abhängig von dem Aktivierungssignal zu starten. Der Vorteil ist, dass das Aktivieren und Deaktivieren und entsprechend das Starten und Stoppen der Oszillatoreinheit über den jeweiligen Steuereingang des mindestens einen Transistors erfolgt. Der Leistungsbedarf für das Aktivieren und Deaktivieren und das Starten und Stoppen ist dadurch besonders gering. Die Vorrichtung kann daher diesbezüglich sehr einfach mit kostengünstigen Bauelementen, zum Beispiel mit Kleinsignalbauelementen, aufgebaut sein. Ferner besteht dadurch die Möglichkeit einer Integration dieser Bauelemente in einem Halbleiterbauelement.

In einer weiteren vorteilhaften Ausgestaltung umfasst die Hilfsoszillatoreinheit einen Multivibrator oder Schmitt-Trigger-Oszillator. Der Vorteil ist, dass die Hilfsoszillatoreinheit dadurch sehr einfach und kostengünstig ausgebildet sein kann und ferner ein zuverlässiges Anregen der Oszillatoreinheit ermöglicht.

Ausführungsbeispiele der Erfindung sind im Folgenden anhand der schematischen Zeichnungen erläutert. Es zeigen:
- Figur 1: eine Vorrichtung mit einer Oszillatoreinheit und einer ersten Ausführungsform einer Hilfsoszillatoreinheit,
- Figur 2: eine zweite Ausführungsform der Hilfsoszillatoreinheit und
- Figur 3: ein Spannungs-Zeit-Diagramm und ein Strom-Zeit-Diagramm.

Elemente gleicher Konstruktion oder Funktion sind figurenübergreifend mit den gleichen Bezugszeichen versehen.

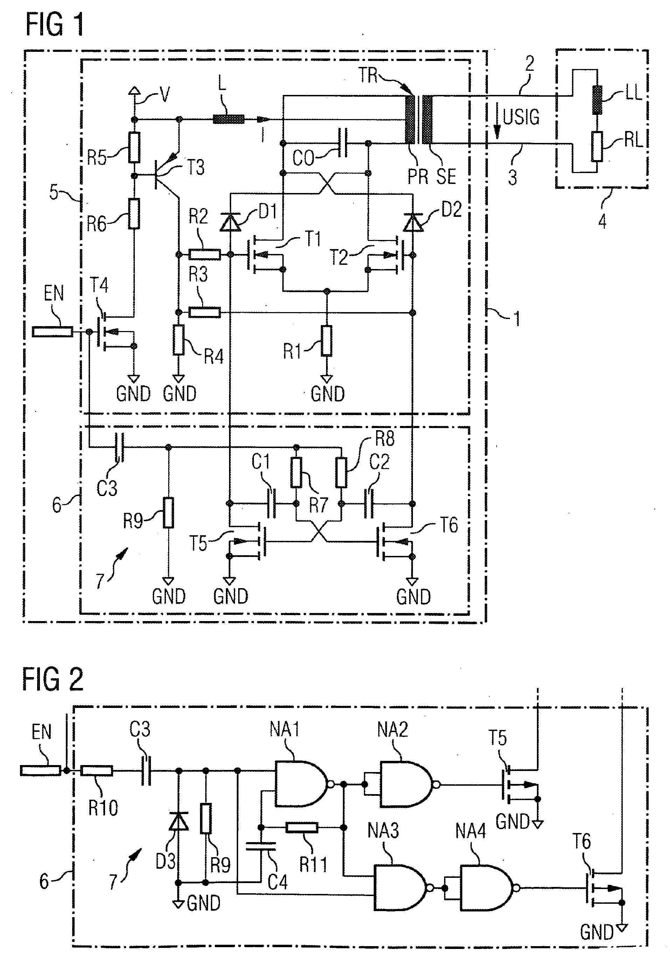

Eine Vorrichtung 1 ist über eine erste Leitung 2 und eine zweite Leitung 3 mit einer elektrischen Last 4, das heißt mit einem elektrischen Verbraucher, gekoppelt (Figur 1). Die Vorrichtung 1 ist beispielsweise ein Steuergerät in einem Kraftfahrzeug und die erste und die zweite Leitung 2, 3 sind beispielsweise in einem Kabelbaum des Kraftfahrzeugs geführt.

Die Vorrichtung 1 ist ausgebildet, ein Ausgangssignal USIG zu erzeugen, das vorzugsweise in Form einer sinusförmigen Wechselspannung mit einer hohen Spannungsamplitude und mit einer ersten Frequenz ausgebildet ist. Die Vorrichtung 1 ist ferner ausgebildet, das Ausgangssignal USIG der Last 4 über die erste und die zweite Leitung 2, 3 zuzuführen. Beispielsweise beträgt die erste Frequenz des Ausgangssignals USIG zwischen etwa 40 und 50 kHz und beträgt dessen Spannungsamplitude etwa 140 V zwischen Maximum und Minimum des Signalverlaufs des Ausgangssignals USIG innerhalb einer Schwingungsperiode. Beispielsweise wird auf diese Weise eine Leistung in einer Größenordnung von etwa 100 bis 200 Watt von der Vorrichtung 1 zu der Last 4 übertragen. Beispielsweise ist die Last 4 ein induktiv beheizbares Kraftstoffeinspritzventil. Jedoch können die erste Frequenz des Ausgangssignals USIG, die Spannungsamplitude und/oder die übertragene Leistung auch größer oder kleiner sein. Ferner ist die Vorrichtung 1 auch mit einer anderen Last 4 betreibbar.

Die Vorrichtung 1 umfasst eine Oszillatoreinheit 5 zum Erzeugen des Ausgangssignals USIG und eine Hilfsoszillatoreinheit 6. Die Oszillatoreinheit 5 ist mit der ersten und der zweiten Leitung 2, 3 gekoppelt. Bevorzugt ist die Oszillatoreinheit 5 ausgebildet, das Ausgangssignal USIG derart zu erzeugen, dass dieses im Wesentlichen symmetrisch ist in Bezug auf ein vorgegebenes Bezugspotential GND. Das Signal wird somit differenziell übertragen. Dies ist besonders günstig in Bezug auf eine elektromagnetische Abstrahlung, die insbesondere bei hochfrequenten Signalen mit großer Spannungsamplitude in störendem Maße auftreten kann und gegebenenfalls andere elektrische Komponenten stören kann. Das vorgegebene Bezugspotential GND ist insbesondere ein Massepotential, zum Beispiel das Potential eines Chassis eines Kraftfahrzeugs. Die Oszillatoreinheit 5 kann jedoch auch anders ausgebildet sein.

Die Oszillatoreinheit 5 umfasst vorzugsweise einen Leistungsoszillator oder ist als eine Leistungsoszillatoreinheit ausgebildet. Die Oszillatoreinheit 5 umfasst einen ersten Transistor T1 und einen zweiten Transistor T2, die vorzugsweise als Leistungstransistoren ausgebildet sind. Ein jeweiliger Source-Anschluss des ersten und des zweiten Transistors T1, T2 ist mit dem vorgegebenen Bezugspotential GND über einen ersten Widerstand R1 gekoppelt. Der erste Widerstand R1 ist beispielsweise vorgesehen, um einen Strom durch den ersten oder den zweiten Transistor T1, T2 anhand eines Spannungsabfalls über dem ersten Widerstand R1 zu erfassen. Der jeweilige Source-Anschluss des ersten und des zweiten Transistors T1, T2 kann jedoch ebenso unmittelbar mit dem vorgegebenen Bezugspotential GND gekoppelt sein. Ein jeweiliger Drain-Anschluss des ersten und des zweiten Transistors T1, T2 ist mit jeweils einem Anschluss einer Oszillatorkapazität CO gekoppelt.

Die Oszillatoreinheit 5 ist ferner so ausgebildet, dass ein jeweiliger Gate-Anschluss des ersten und des zweiten Transistors T1, T2 abwechselnd angesteuert wird. Der jeweilige Gate-Anschluss bildet einen jeweiligen Steuereingang des ersten beziehungsweise des zweiten Transistors T1, T2. Der Steuereingang des ersten Transistors T1 ist über eine erste Diode D1 mit dem Drain-Anschluss des zweiten Transistors T2 gekoppelt. Entsprechend ist der Steuereingang des zweiten Transistors T2 über eine zweite Diode D2 mit dem Drain-Anschluss des ersten Transistors T1 gekoppelt.

Die Oszillatoreinheit 5 umfasst ferner einen Transformator TR mit einer Primärwicklung PR und einer Sekundärwicklung SE. Die Primärwicklung PR ist elektrisch parallel zu der Oszillatorkapazität CO angeordnet. Die Primärwicklung weist einen Mittelabgriff auf, der über eine Entkopplungsinduktivität L mit einem vorgegebenen Versorgungspotential V gekoppelt ist. Eine Spannung zwischen dem vorgegebenen Versorgungspotential V und dem vorgegebenen Bezugspotential GND beträgt beispielsweise etwa zwölf Volt. Diese Spannung kann jedoch auch größer oder kleiner als zwölf Volt sein. Während eines Betriebs der Oszillatoreinheit 5 fließt durch die Entkopplungsinduktivität L ein Strom I.

Die Sekundärwicklung SE ist mit der ersten und der zweiten Leitung 2, 3 gekoppelt. Die Last 4 umfasst beispielsweise eine Lastinduktivität LL und einen Lastwiderstand RL, die elektrisch in Reihe angeordnet sind. Die Lastinduktivität LL und der Lastwiderstand RL bilden mit der Sekundärwicklung SE und der ersten und der zweiten Leitung 2, 3 einen Stromkreis.

Die erste Frequenz des über die erste und die zweite Leitung 2, 3 übertragbaren Ausgangssignals USIG ist im Wesentlichen durch einen Kapazitätswert der Oszillatorkapazität CO und durch einen Induktivitätswert vorgegeben, der durch die elektrisch parallel zueinander angeordnete Primärwicklung PR des Transformators TR und der durch den Transformator TR transformierten Lastinduktivität LL gebildet ist.

Um das Ausgangssignal USIG erzeugen zu können, muss dem jeweiligen Steuereingang des ersten und des zweiten Transistors T1, T2 eine Vorspannung zugeführt werden, die größer ist als eine Schwellenspannung des ersten beziehungsweise des zweiten Transistors T1, T2. Dazu ist der jeweilige Steuereingang über einen zweiten Widerstand R2 beziehungsweise einen dritten Widerstand R3 elektrisch mit einem Kollektor-Anschluss eines dritten Transistors T3 gekoppelt. Der dritte Transistor T3 ist vorzugsweise als ein Kleinsignaltransistor ausgebildet. Der dritte Transistor T3 ist mit seinem Emitteranschluss mit dem vorgegebenen Versorgungspotential V gekoppelt. Ferner sind der zweite und der dritte Widerstand R2, R3 und der Kollektor-Anschluss des dritten Transistors T3 über einen vierten Widerstand R4 mit dem vorgegebenen Bezugspotential GND gekoppelt. Der vierte Widerstand R4 stellt ein zuverlässiges Ausschalten des ersten und des zweiten Transistors T1, T2 sicher, wenn der dritte Transistor T3 gesperrt ist.

Ein Basis-Anschluss des dritten Transistors T3 ist über einen fünften Widerstand R5 mit dem vorgegebenen Versorgungspotential V gekoppelt und ist über einen sechsten Widerstand R6 und einen vierten Transistor T4 mit dem vorgegebenen Bezugspotential GND koppelbar. Der vierte Transistor T4 ist dazu elektrisch zwischen dem sechsten Widerstand R6 und dem vorgegebenen Bezugspotential GND angeordnet. Ein Gate-Anschluss des vierten Transistors T4 ist elektrisch mit einem Aktivierungseingang EN der Oszillatoreinheit 5 gekoppelt. Der vierte Transistor T4 ist vorzugsweise als ein Kleinsignaltransistor ausgebildet.

Abhängig von einem Aktivierungssignal, das dem Aktivierungseingang EN zuführbar ist und das zum Beispiel durch einen digitalen High-Pegel gebildet ist, wird der vierte Transistor T4 eingeschaltet. Infolgedessen wird auch der dritte Transistor T3 eingeschaltet und hebt dadurch ein Potential an dem jeweiligen Steuereingang des ersten und des zweiten Transistors T1, T2 in Richtung des vorgegebenen Versorgungspotentials V an, so dass zwischen dem Steuereingang des ersten und des zweiten Transistors T1, T2 und dem vorgegebenen Bezugspotential GND die Vorspannung anliegen kann. Durch das Aktivierungssignal ist das Zuführen der Vorspannung somit aktivierbar.

Der erste und der zweite Transistor T1, T2 bilden jeweils einen Schleifenverstärker der Oszillatoreinheit 5, der mit seiner jeweiligen Schleifenverstärkung einen Schwingkreis entdämpft, der im Wesentlichen durch die Oszillatorkapazität CO und die elektrisch parallel zueinander angeordnete Primärwicklung PR und transformierte Lastinduktivität LL gebildet ist. Schwingt die Oszillatoreinheit 5 mit der ersten Frequenz, werden der erste und der zweite Transistor T1, T2 aufgrund der Rückkopplung über die erste und die zweite Diode D1, D2 abwechselnd und wechselseitig ein- und ausgeschaltet. Das resultierende Ausgangssignal USIG ist im Wesentlichen sinusförmig.

Ferner ist das Zuführen der Vorspannung auch deaktivierbar abhängig von dem Aktivierungssignal, zum Beispiel wenn dieses einen digitalen Low-Pegel einnimmt. Der vierte Transistor T4 und somit auch der dritte Transistor T3 sperren dann und der jeweilige Steuereingang des ersten und des zweiten Transistors T1, T2 liegt über den vierten Widerstand R4 und über den zweiten beziehungsweise den dritten Widerstand R2, R3 auf dem vorgegebenen Bezugspotential GND. Der erste und der zweite Transistor T1, T2 sind dann ausgeschaltet und das Ausgangssignal USIG wird nicht erzeugt.

Die Oszillatoreinheit 5 weist gegebenenfalls ein unzureichendes Anschwingverhalten auf, insbesondere wenn ein Widerstandswert des Lastwiderstands RL gering ist. Die Schleifenverstärkung der Oszillatoreinheit 5 reicht dann gegebenenfalls nicht aus, um ein zuverlässiges Anschwingen der Oszillatoreinheit 5 zu gewährleisten. Dadurch besteht die Gefahr, dass sowohl der erste als auch der zweite Transistor T1, T2 zumindest für eine kurze Zeitdauer gleichzeitig eingeschaltet sind und dadurch der Strom I durch die Entkopplungsinduktivität L, die Primärwicklung PR und den ersten und den zweiten Transistor T1, T2 sehr groß wird, das heißt eine Stromspitze erzeugt wird. Eine solche Stromspitze kann beispielsweise mehr als 50 Ampere groß sein bei einem für den Betrieb der Oszillatoreinheit 5 vorgesehenen Strom I von etwa 10 bis 16 Ampere. Dies kann die Lebensdauer und Zuverlässigkeit der Oszillatoreinheit 5 erheblich beeinträchtigen. Ferner kann durch die Stromspitze eine elektromagnetische Abstrahlung unzulässig erhöht sein, so dass gegebenenfalls aufwändige Filtermaßnahmen vorgesehen sein müssen, um gegebenenfalls vorgesehene Grenzwerte bezüglich der elektromagnetischen Verträglichkeit, kurz: EMV, einhalten zu können.

Zur Vermeidung der Stromspitze und die mit dieser einhergehenden Beeinträchtigungen und zum Sicherstellen eines zuverlässigen und gleichmäßigen Anschwingens der Oszillatoreinheit 5 umfasst die Vorrichtung 1 die Hilfsoszillatoreinheit 6, die mit der Oszillatoreinheit 5 elektrisch gekoppelt ist. Eine erste Ausführungsform der Hilfsoszillatoreinheit 6 ist als eine astabile Kippstufe ausgebildet. Die astabile Kippstufe kann auch als ein Multivibrator bezeichnet werden. Dieser umfasst einen fünften Transistor T5 und einen sechsten Transistor T6. Der fünfte und der sechste Transistor T5, T6 sind vorzugsweise als Kleinsignalstransistoren ausgebildet.

Ein jeweiliger Source-Anschluss des fünften und des sechsten Transistors T5, T6 ist mit dem vorgegebenen Bezugspotential GND gekoppelt. Ein Drain-Anschluss des fünften Transistors T5 ist mit dem Steuereingang des ersten Transistors T1 gekoppelt und ein Drain-Anschluss des sechsten Transistors T6 ist mit dem Steuereingang des zweiten Transistors T2 gekoppelt. Ferner ist der Drain-Anschluss des fünften Transistors T5 über einen ersten Kondensator C1 mit einem Gate-Anschluss des sechsten Transistors T6 gekoppelt. Entsprechend ist der Drain-Anschluss des sechsten Transistors T6 über einen zweiten Kondensator C2 mit einem Gate-Anschluss des fünften Transistors T5 gekoppelt. Ferner umfasst der Multivibrator einen siebten und einen achten Widerstand R7, R8, die mit dem Gate-Anschluss des sechsten Transistors T6 beziehungsweise mit dem Gate-Anschluss des fünften Transistors T5 gekoppelt sind. Der zweite und der dritte Widerstand R2, R3 der Oszillatoreinheit 5 bilden jeweils einen Lastwiderstand des Multivibrators.

Die Hilfsoszillatoreinheit 6 weist ferner ein Zeitglied 7 auf, das einen dritten Kondensator C3 und einen neunten Widerstand R9 umfasst, die jeweils mit dem siebten und dem achten Widerstand R7, R8 elektrisch gekoppelt sind. Der jeweilige Gate-Anschluss des fünften und des sechsten Transistors T5, T6 ist über den siebten beziehungsweise den achten Widerstand R7, R8 und über den dritten Kondensator C3 mit dem Aktivierungseingang EN gekoppelt. Ferner ist der jeweilige Gate-Anschluss des fünften und des sechsten Transistors T5, T6 über den siebten beziehungsweise den achten Widerstand R7, R8 und über den neunten Widerstand R9 mit dem vorgegebenen Bezugspotential GND gekoppelt.

Springt das Aktivierungssignal an dem Aktivierungseingang EN zum Beispiel von dem Low-Pegel auf den High-Pegel, dann erhalten der fünfte und der sechste Transistor T5, T6 an ihrem jeweiligen Gate-Anschluss eine Spannung zugeführt, die für eine vorgegebene Zeitdauer einen Betrieb der Hilfsoszillatoreinheit 6 und insbesondere des Multivibrators ermöglicht. Ferner ist der jeweilige Drain-Anschluss des fünften und des sechsten Transistors T5, T6 bei aktivierter Vorspannung des ersten und des zweiten Transistors T1, T2 über den zweiten beziehungsweise den dritten Widerstand R2, R3 und den dritten Transistor T3 mit dem vorgegebenen Versorgungspotential V gekoppelt, so dass der Multivibrator anschwingen kann. Die vorgegebene Zeitdauer ist im Wesentlichen abhängig von einem Kapazitätswert des dritten Kondensators C3 und einem Widerstandswert des neunten Widerstands R9. Die vorgegebene Zeitdauer beträgt beispielsweise etwa 100 Mikrosekunden. Die vorgegebene Zeitdauer kann jedoch auch länger oder kürzer als 100 Mikrosekunden vorgegeben sein.

Die Hilfsoszillatoreinheit 6 und insbesondere der Multivibrator schwingt mit einer zweiten Frequenz, die im Wesentlichen durch einen jeweiligen Kapazitätswert des ersten und des zweiten Kondensators C1, C2 und durch einen jeweiligen Widerstandswert des siebten und achten Widerstands R7, R8 vorgegeben ist. Die zweite Frequenz ist so gewählt, dass diese größer ist als die erste Frequenz. Beispielsweise beträgt die erste Frequenz zwischen etwa 40 und 50 kHz und beträgt die zweite Frequenz etwa 60 kHz. Die erste und/oder die zweite Frequenz können jedoch auch größer oder kleiner sein.

Der Multivibrator ist ausgebildet, den fünften und den sechsten Transistor T5, T6 abwechselnd und wechselseitig ein- und auszuschalten, so dass im Wesentlichen immer nur einer der beiden Transistoren eingeschaltet ist. Durch die Kopplung des fünften Transistors T5 mit dem Steuereingang des ersten Transistors T1 und durch die Kopplung des sechsten Transistors T6 mit dem Steuereingang des zweiten Transistors T2 erfolgt eine Zwangssteuerung des ersten und des zweiten Transistors T1, T2 und somit der Oszillatoreinheit 5 durch die Hilfsoszillatoreinheit 6. Abwechselnd wird der jeweilige Steuereingang des ersten und des zweiten Transistors T1, T2 durch den fünften beziehungsweise durch den sechsten Transistor T5, T6 auf das vorgegebene Bezugspotential GND gezogen, so dass der betreffende Transistor ausschaltet. Dadurch, dass die zweite Frequenz größer ist als die erste Frequenz, wird die Oszillatoreinheit 5 ferner mit der Hilfsoszillatoreinheit 6 zwangssynchronisiert. Dadurch ist sichergestellt, dass auch im Wesentlichen nur entweder der erste oder der zweite Transistor T1, T2 eingeschaltet ist. Dadurch wird das Entstehen der Stromspitze zuverlässig verhindert.

Über den siebten beziehungsweise achten Widerstand R7, R8 und den neunten Widerstand R9 wird die Spannung an dem jeweiligen Gate-Anschluss des fünften und des sechsten Transistors T5, T6 wieder auf das vorgegebene Bezugspotential GND zurückgeführt und der fünfte und der sechste Transistor T5, T6 werden so zuverlässig gesperrt. Sind der fünfte und der sechste Transistor T5, T6 gesperrt, dann erfolgt das Schwingen der Oszillatoreinheit 5 und das Erzeugen des Ausgangssignals USIG im Wesentlichen unbeeinflusst durch die Hilfsoszillatoreinheit 6 mit der ersten Frequenz. Dadurch kann das Ausgangssignal USIG besonders verlustarm erzeugt werden.

Figur 2 zeigt eine alternative zweite Ausführungsform der Hilfsoszillatoreinheit 6, die als ein Schmitt-Trigger-Oszillator ausgebildet ist. Der Schmitt-Trigger-Oszillator ist beispielsweise sehr einfach mittels Logik-Gattern implementierbar.

Der Aktivierungseingang EN ist elektrisch über einen zehnten Widerstand R10 und über den dritten Kondensator C3 mit einem ersten Eingang eines ersten Gatters NA1 gekoppelt. Das erste Gatter NA1 ist beispielsweise als ein NAND-Gatter ausgebildet. Dieser erste Eingang des ersten Gatters NA1 ist ferner über den neunten Widerstand R9 und eine dritte Diode D3, die elektrisch parallel zueinander angeordnet sind, mit dem vorgegebenen Bezugspotential GND gekoppelt. Ein zweiter Eingang des ersten Gatters NA1 ist über einen vierten Kondensator C4 mit dem vorgegebenen Bezugspotential GND gekoppelt und ferner über einen elften Widerstand R11 mit einem Ausgang des ersten Gatters NA1 gekoppelt. Das erste Gatter NA1, der elfte Widerstand R11 und der vierte Kondensator C4 bilden einen Schmitt-Trigger. Der Ausgang des ersten Gatters NA1 ist über ein zweites Gatter NA2 mit dem Gate-Anschluss des fünften Transistors T5 gekoppelt. Das zweite Gatter NA2 ist beispielsweise ein Inverter, kann jedoch auch durch ein entsprechend beschaltetes NAND-Gatter gebildet sein.

Ein drittes Gatter NA3, das beispielsweise durch ein NAND-Gatter gebildet ist, und ein viertes Gatter NA4, das beispielsweise durch einen Inverter oder ein entsprechend beschaltetes NAND-Gatter gebildet ist, sind vorgesehen zur Ansteuerung des sechsten Transistors T6. Ein erster Eingang des dritten Gatters NA3 ist mit dem Ausgang des ersten Gatters NA1 gekoppelt. Ein zweiter Eingang des dritten Gatters NA3 ist mit dem ersten Eingang des ersten Gatters NA1 gekoppelt. Ein Ausgang des dritten Gatters NA3 ist über das vierte Gatters NA4 mit dem Gate-Anschluss des sechsten Transistors T6 gekoppelt.

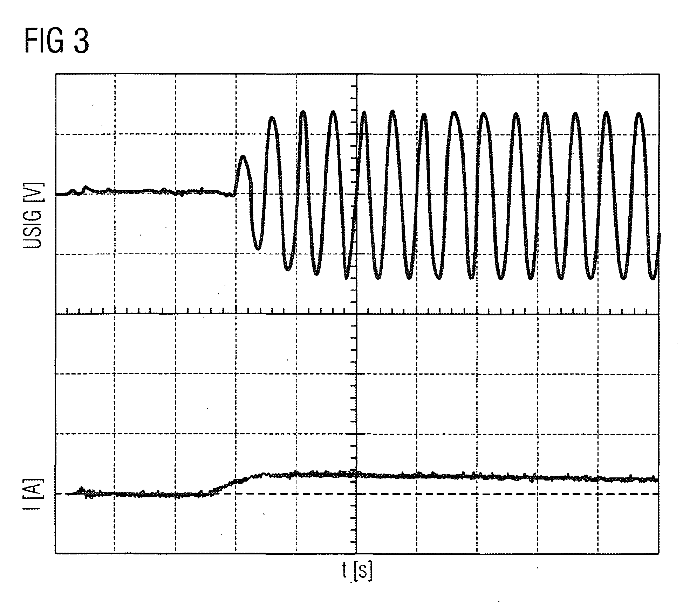

Figur 3 zeigt ein Spannungs-Zeit-Diagramm mit einem Signalverlauf des Ausgangssignals USIG nach dem Start der Oszillatoreinheit 5 und der Hilfsoszillatoreinheit 6 durch das Aktivierungssignal. Figur 3 zeigt ferner ein Strom-Zeit-Diagramm mit einem zugehörigen Verlauf des Stroms I. Die Stromspitze ist vollständig unterdrückt und die Oszillatoreinheit schwingt sicher, zuverlässig und gleichmäßig an.

Die Oszillatoreinheit 5 und/oder die Hilfsoszillatoreinheit 6 können auch anders ausgebildet sein. Beispielsweise kann in der Oszillatoreinheit 5 auch nur ein Transistor vorgesehen sein, der einen Schleifenverstärker der Oszillatoreinheit für das Erzeugen des Ausgangssignal USIG repräsentiert, insbesondere wenn das Ausgangssignal USIG nicht differenziell erzeugt wird. Entsprechend muss die Hilfsoszillatoreinheit nur diesen einen Transistor zwangssteuern.

## Patentansprüche

1. Vorrichtung, die mit einer elektrischen Last (4) koppelbar ist zum Zuführen von elektrischer Energie zu der elektrischen Last (4), die umfasst
- eine Oszillatoreinheit (5), die ausgebildet ist, ein Ausgangssignal (USIG) der Vorrichtung (1) zu erzeugen, das der elektrischen Last (4) zuführbar ist und das eine erste Frequenz aufweist, und
- eine Hilfsoszillatoreinheit (6), die mit der Oszillatoreinheit (5) elektrisch gekoppelt ist und die ausgebildet ist, die Oszillatoreinheit (5) zum Schwingen anzuregen mit einer zweiten Frequenz, die größer ist als die erste Frequenz, und die ein Zeitglied (7) umfasst, das ausgebildet und angeordnet ist, das Anregen der Oszillatoreinheit (5) nach Ablauf einer vorgegebenen Zeitdauer nach einem Start der Oszillatoreinheit (5) und der Hilfsoszillatoreinheit (6) zu beenden.

2. Vorrichtung nach Anspruch 1, bei der die Oszillatoreinheit (5) mindestens einen Transistor umfasst, der einen Schleifenverstärker für das Erzeugen des Ausgangssignals (USIG) repräsentiert, und die Hilfsoszillatoreinheit (6) mit einem Steuereingang des mindestens einen Transistors gekoppelt ist zum Ansteuern des mindestens einen Transistors.

3. Vorrichtung nach Anspruch 2, bei der in der Oszillatoreinheit (5) zwei Transistoren vorgesehen sind, die jeweils einen Schleifenverstärker für das Erzeugen des Ausgangssignals (USIG) repräsentieren, und die Hilfsoszillatoreinheit (6) ausgebildet ist, die zwei Transistoren abwechselnd anzusteuern.

4. Vorrichtung nach einem der Ansprüche 2 oder 3, bei der
- die Oszillatoreinheit (5) und die Hilfsoszillatoreinheit (6) einen gemeinsamen Aktivierungseingang (EN) aufweisen,
- die Oszillatoreinheit (5) ausgebildet ist, ein Zuführen einer Vorspannung, die für das Erzeugen der Ausgangsspannung (USIG) erforderlich ist, zu dem Steueranschluss des mindestens einen Transistors abhängig von einem Aktivierungssignal an dem Aktivierungseingang (EN) zu aktivieren oder deaktivieren, und
- die Hilfsoszillatoreinheit (6) ausgebildet ist, das Zeitglied (7) abhängig von dem Aktivierungssignal zu starten.

5. Vorrichtung nach einem der vorstehenden Ansprüche, bei der die Hilfsoszillatoreinheit (6) einen Multivibrator oder Schmitt-Trigger-Oszillator umfasst.

## Claims

1. Device which can be coupled to an electrical load (4) for the purpose of supplying electrical energy to the electrical load (4), comprising
- an oscillator unit (5) which is designed to generate an output signal (USIG) of the device (1), wherein said output signal can be supplied to the electrical load (4) and has a first frequency, and
- an auxiliary oscillator unit (6) which is electrically coupled to the oscillator unit (5) and is designed to stimulate the oscillator unit (5) to oscillate, using a second frequency that is higher than the first frequency, and which includes a timing element (7) that is designed and arranged for the purpose of terminating the stimulation of the oscillator unit (5) after expiry of a predetermined time period following startup of the oscillator unit (5) and the auxiliary oscillator unit (6).

2. Device according to claim 1, in which the oscillator unit (5) comprises at least one transistor which represents a loop amplifier for the generation of the output signal (USIG), and the auxiliary oscillator unit (6) is coupled to a control input of the at least one transistor for the purpose of triggering the at least one transistor.

3. Device according to claim 2, in which two transistors are provided in the oscillator unit (5), each representing a loop amplifier for the generation of the output signal (USIG), and the auxiliary oscillator unit (6) is designed to trigger the two transistors alternately.

4. Device according to one of the claims 2 or 3, in which
- the oscillator unit (5) and the auxiliary oscillator unit (6) have a shared activation input (EN),
- the oscillator unit (5) is designed to activate or deactivate a supply of a bias voltage, which is required for the generation of the output voltage (USIG), to the control interface of the at least one transistor, depending on an activation signal at the activation input (EN), and
- the auxiliary oscillator unit (6) is designed to start the timer (7) depending on the activation signal.

5. Device according to one of the preceding claims, in which the auxiliary oscillator unit (6) comprises a multivibrator or Schmitt trigger oscillator.

## Revendications

1. Dispositif pouvant être couplé à une charge électrique (4) pour amener une énergie électrique à la charge électrique (4), qui comprend :
- une unité formant oscillateur (5), qui est configurée pour générer un signal de sortie (USIG) du dispositif (1), lequel signal peut être amené à la charge électrique (4), et qui présente une première fréquence, et
- une unité (6) formant oscillateur auxiliaire, qui est électriquement couplée à l'unité formant oscillateur (5) et qui est configurée pour stimuler l'unité formant oscillateur (5) pour l'amener à osciller à une deuxième fréquence supérieure à la première fréquence, et qui comprend un relais temporisé (7), qui est configuré et agencé pour mettre fin à la stimulation de l'unité formant oscillateur (5) après écoulement d'un laps de temps prédéfini, après un démarrage de l'unité formant oscillateur (5) et de l'unité formant oscillateur auxiliaire (6).

2. Dispositif selon la revendication 1, dans lequel l'unité formant oscillateur (5) comprend au moins un transistor, qui représente un amplificateur de boucle pour la génération du signal de sortie (USIG), et l'unité formant oscillateur auxiliaire (6) est couplée à une entrée de commande du au moins un transistor pour diriger le au moins un transistor.

3. Dispositif selon la revendication 2, dans lequel sont prévus dans l'unité formant oscillateur (5) deux transistors qui représentent respectivement un amplificateur de boucle pour la génération du signal de sortie (USIG), et l'unité formant oscillateur auxiliaire (6) est configurée pour diriger les deux transistors en alternance.

4. Dispositif selon l'une des revendications 2 ou 3, dans lequel
- l'unité formant oscillateur (5) et l'unité formant oscillateur auxiliaire (6) présentent une entrée d'activation (EN) commune,
- l'unité formant oscillateur (5) est configurée pour activer ou désactiver une amenée d'une prétension, nécessaire à la génération de la tension de sortie (USIG) vers la borne de commande du au moins un transistor, en fonction d'un signal d'activation appliqué à l'entrée d'activation (EN), et
- l'unité formant oscillateur auxiliaire (6) est configurée pour lancer le relais temporisé (7) en fonction du signal d'activation.

5. Dispositif selon l'une des revendications précédentes, dans lequel l'unité formant oscillateur auxiliaire (6) comprend un multivibrateur ou un oscillateur à bascule de Schmitt.
